# EUROPÄISCHE PATENTSCHRIFT

(11) **EP 1 265 075 B1**
(45) Veröffentlichungstag und Bekanntmachung des Hinweises auf die Patenterteilung: **11.04.2007**
(21) Anmeldenummer: 02012558.9
(22) Anmeldetag: 05.06.2002
(51) Int. Cl.: G01R 15/22

(54) **Potentialfreie analoge Signalübertragung mit Kalibrierfunktion**
Floating analog signal transmission having a calibration function
Transmission de signal analogique à potentiel libre avec fonction de calibrage

(30) Priorität: 07.06.2001 DE 10127804
(43) Veröffentlichungstag der Anmeldung: 11.12.2002
(73) Patentinhaber: SIEMENS AKTIENGESELLSCHAFT, 80333 München (DE)
(72) Erfinder: Bechtold, Mario, 91334 Hemhofen (DE)

(56) Entgegenhaltungen:
- DE-C- 19 827 225
- US-A- 4 070 572
- US-A- 4 290 146
- US-A- 4 316 141
- US-A- 4 810 873

## Beschreibung

Die vorliegende Erfindung bezieht sich auf ein Verfahren zur potentialfreien analogen Signalübertragung mit Kalibrierfunktion für ein an einer Quelle auftretendes elektrisches Wechselspannungssignal. Weiter bezieht sich die vorliegende Erfindung auf eine potentialfreie analoge Signalübertragungsvorrichtung mit Kalibrierfunktion für das elektrische Wechselspannungssignal der Quelle. Ferner betrifft die vorliegende Erfindung eine Anwendung des Verfahrens und auch eine Anwendung der Signalübertragungsvorrichtung.

Seit Jahrzehnten ist es in der Hochspannungstechnik und insbesondere in der Technik der Hochspannungs-Energieverteilung üblich, elektrische Spannungen und fließende elektrische Ströme am Ort hoher elektrischer Potentiale zu messen. Da eine direkte elektrische Verbindung zwischen einem solchen Ort auf hohem elektrischem Potential und z.B. Erdpotential technische Probleme aufwirft, ist es seit langem bekannt, derartige elektrische Messdaten in optische Signale umgesetzt auf optischem Wege zu übertragen. Verwendet wurden und werden hierzu insbesondere solche Messeinrichtungen für elektrische Ströme, die von diesen Strömen erzeugte Magnetfelder messen, und zwar unter Nutzung des elektro-optischen Faraday- oder Kerr-Effekts, die Drehung der Polarisationsebene oder Doppel-Brechung des optischen Verhaltens in einem Magnetfeld beschreiben.

Aus der US 4,070,572 A ist es bekannt, bei Wechselstromhochspannungsleitungen an einem Shunt-Widerstand ein Wechselspannungssignal abzugreifen, wobei die eingangs genannten Merkmale zur Anwendung kommen. Zur Transformation des Wechselspannungssignals in ein optisches Signal wird eine LED verwendet, die Teil einer auf Hochspannungspotential befindlichen Elektronik mit operationsverstärker ist. Die Energieversorgung dieser Elektronik erfolgt dabei von einer besonderen Energieversorgungsquelle aus, die einen weiteren Shunt-Widerstand an der Hochspannungsleitung umfassen kann. Außerdem ist eine Standby-Batterie zur Energieversorgung in Zeiten fehlender Wechselspannung vorgesehen.

Auch aus der US 4,316,141 A ist eine Messvorrichtung mit optischer Signalübertragung für eine Hochspannungsleitung bekannt. Zum Betrieb einer Elektronik auf Hochspannungspotential soll ebenfalls eine besondere Spannungsquelle vorgesehen werden. Einzelheiten dieser Spannungsquelle sind nicht erläutert.

In der US 4,810,873 sind ein Verfahren und eine Einrichtung zur automatischen Dämpfungs-Kompensation einer faseroptischen Messwertübertragung angegeben. Messwertsignale von einem auf Hochspannungspotential angeordneten Signalgeber, die von einem Signalsensor mit einer Sendediode auf der Hochspannungs-Seite über einen Lichtleiter zu einem Signalempfänger mit einer Photodiode auf Erdpotential übertragen werden, unterliegen in der Regel unterwegs einer optischen Signaldämpfung. Um eine automatische Dämpfungskompensation sowohl für Wechselals auch für Gleichspannungsmesssignale zu gewährleisten, wird der Sendediode ein Referenz-Gleichstrom rückgeführt. Vor jeder Messung erfolgt ein Abgleich des Übertragungssystems. Dabei wird ein Verstärker des Signalsenders eingangsseitig über einen Schalter mit einem Bezugspotential verbunden und der Verstärkungsfaktor des Signalempfängers so geregelt, dass dessen Ausgangssignal gleich einer vorgebbaren Vergleichsspannung ist. Das Ausgangssignal eines Differenzverstärkers wird über ein Tiefpassfilter und einen ersten Nachverstärker einem Momentanwert-Speicher zugeführt, dessen Ausgangssignal den Verstärkungsfaktor steuert. Nach Erreichen des abgeglichenen Zustandes wird der Regelkreis unterbrochen, so dass der Verstärkungsfaktor bis zu einem erneuten Abgleich konstant bleibt. Der Verstärkungsfaktor kann über elektrisch, elektromechanisch oder optisch steuerbare Widerstände oder einem Multiplikator oder über die Vorspannung einer Avalache-Photodiode eingestellt werden.

In der US 4,290,146 ist ein Übertragungsgerät zur Übertragung von Signalen über eine optische Verbindung angegeben. Dabei dient das Gerät zur Übertragung eines Ausgangssignals eines Messgeräts über eine gewisse Entfernung auf ein anderes elektrisches Potentialniveau. Das Übertragungsgerät besteht aus einem Sender und einem Empfänger, die über eine optische Übertragungsverbindung verbunden sind. Auf der Senderseite befinden sich Vergleichsglieder, welche die Eingangsgröße der zu übertragenden Größe mit einem vom Empfänger gelieferten Rückführungssignal vergleichen. Das Differenzsignal wird zum Empfänger übertragen, wo es einen Regler steuert, dessen Ausgangssignal sowohl das Rückführungssignal wie das Ausgangssignal des Übertragungsgerätes ist. Das Übertragungsgerät enthält ferner Glieder zur automatischen Konstanthaltung der Verstärkung in der Übertragungsverbindung für das Rückführungssignal.

Aus der US 5,107,202 ist eine faseroptische Stromüberwachungseinrichtung für Hochspannungsanwendungen bekannt. Die Einrichtung weist Paare von identischen Übertragermodulen auf, welche in zueinander entgegengesetzten Polaritäten in Serie mit dem zu überwachenden Leiter verbunden sind. Hierbei wird ein erstes Lichtsignal während eines Zeitintervalls von einem Modul eines Modulpaars erzeugt, wobei die Intensität des Lichtsignals direkt proportional zur Stromstärke ist, die in eine Richtung durch den Leiter fließt. Das andere Modul des Modulpaars erzeugt ein zweites Lichtsignal während eines anderen Zeitabschnitts, wobei die Intensität des Lichtsignals direkt proportional zur Stromstärke ist, welche in die entgegengesetzte Richtung durch den Leiter fließt. Ein auf einem anderen Potential, insbesondere Erdpotential, angeordneter Empfänger empfängt dann die Signale und wandelt sie in Spannungssignale um. Die Höhe der Spannungssignale gibt dabei Auskunft über die Stromstärke während einer vorgegebenen Messzeit.

In der US 5,724,363 ist ebenfalls ein optisches Analogsignalübertragungssystem angegeben. Das Signalübertragungssystem nutzt zwei optische Übertragungskanäle mit Schaltern und Kalibrierungsschaltkreisen, welche von einem Steuerungssystem betrieben werden, derart, dass ein Kanal das Signal trägt, während der andere Kanal kalibriert wird.

Im Fachbuch von Delaney, C.F.G.: "Electronics for the Physicist with Applications", Ellis Harwood Ltd., 1980, S. 215 - 222 sind verschiedene spannungsstabilisierende Schaltungen angegeben. Die Schaltungen sind dabei jeweils mit einer spannungsstabilisierenden Zener-Diode ausgeführt.

Anderweitig bekannt ist, für die Übertragung analoger Signale zwischen verschiedenen Potentialen ebenfalls eine optische Wegstrecke vorzusehen, an deren einem Ende über eine Lichtdiode (LED) in diese Wegstrecke ein analoges optisches Signal eingegeben wird und am anderen Ende dieser Wegstrecke mittels eines optischen Sensors das über diese Wegstrecke optisch zu übertragende analoge Signal wieder in ein elektrisches Signal umzusetzen. Da bei analoger Signalübertragungsvorrichtung zeitlich unterschiedliche Dämpfungseigenschaften und dergleichen der optischen Wegstrecke auf die jeweilige Höhe des empfangenen Signals Einfluss haben, ist für analoge Signalübertragungsvorrichtung erforderlich, den Wechsel dieser Dämpfung entsprechend geltender Vorgaben zu berücksichtigen, insbesondere in das Ergebnis einzubeziehen. Zum Beispiel ist dies für eine Anwendung der Erfindung von besonderem Interesse und diese Anwendung wird nachfolgend näher beschrieben.

Es ist Praxis, in Hochspannungsnetzen die jeweilige Stromleitung unterbrechende Schalter vorzusehen, die z.B. im Kurzschlussfalle automatisch gesteuert ausgelöst werden. Um noch raschere Stromunterbrechung zu erhalten, als sie mit solchen mechanischen Abschaltern erreichbar sind, können neuerdings bekanntermaßen zusätzlich in Reihe mit solchen Abschaltern Supraleiter-Strombegrenzer eingesetzt werden (Argonne Nat. Lab. Nov. 1, 1991 und March 16, 1995).

Aus der DE 198 27 225 C1 ist ein resistiver Strombegrenzer bekannt, welcher mit mindestens einem mäanderförmigen Streifenleiter aus supraleitendem material ausgeführt ist. Der Streifenleiter ist dabei über einen Teil seiner Länge in zwei oder mehrere Teilstreifen getrennt.

Im Normalfall des Betriebes ist der Stromweg in derartigen Supraleiter-Strombegrenzern supraleitend und damit verlustlos. Würde jedoch aufgrund äußerer Umstände, z.B. eines Kurzschlusses im Netz, ein mehr als zulässig großer elektrischer Strom zu fließen beginnen, geht die supraleitende Eigenschaft des Begrenzers in normalleitenden Zustand über. Dies entspricht dem Auftreten eines vergleichsweise hohen elektrischen Widerstandes im Begrenzer mit gleichzeitigem Spannungsabfall an der ansonsten bisher supraleitenden Strecke des Begrenzers. Einem solchen Zustand darf das Supraleiter-Element des Begrenzers jedoch nur für eine ganz kurze Zeitdauer ausgesetzt sein, nämlich bis der schon oben erwähnte mechanische Abschalter wirksam geworden ist. Diese Zeitdauer wird durch die Dimensionierung des mechanischen Abschalters bestimmt. Die Bemessung ist so gewählt, dass die am jeweiligen Supraleiter-Element bei dessen normalleitendem Zustand anliegende bzw. auftretende elektrische Leistung das Supraleiter-Element nicht zerstört. Das Auftreten des Übergangs aus Supraleitung in Normalleitung kann aber vorteilhafterweise auch als extrem rasches Auslöse-Steuersignal für diesen mechanischen Stromunterbrecher genutzt werden. Die Realisierung dieses Gedankens erfordert, dass möglichst rasch und absolut zuverlässig das Auftreten des Übergangs von Supraleitung in Normalleitung messtechnisch erfasst werden kann. Dabei ist zu berücksichtigen, dass dieses physikalische Ereignis im praktischen Falle in einem Bereich auftritt, der auf Hochspannungspotential gegenüber Erde liegt. Eine weitergehende Forderung der weiterentwickelten Technik ist, den Vorgang des Übergangs aus Supraleitung in Normalleitung zeitlich differenziert zu erfassen, um diesen Vorgang auswerten zu können. Vorteilhafterweise besteht nämlich zusätzlich die Möglichkeit, die einzelnen in einem solchen supraleitenden Strombegrenzer enthaltenen Supraleiter-Elemente im Zeitintervall des erwähnten Überganges bis zum Eintritt des Abschaltens des Stromflusses zu überwachen und Informationen darüber zu sammeln, in welchem funktionellen Zustand sich die betroffenen Supraleiter-Elemente insbesondere jeweils nach einem solchen Übergang befinden. Mit diesbezüglichen Messergebnissen wird entschieden, ob nach einem solchen Übergang einzelne, und zwar welche Supraleiter-Elemente notwendigerweise oder gegebenenfalls auch nur vorsichtshalber für den weiteren Betrieb des Begrenzers ausgewechselt werden müssen oder sollten. Dies gilt insbesondere für diejenigen Fälle, in denen Lichtbögen am Supraleiter-Element aufgetreten sind.

Für die erwähnte Aufgabenstellung ist es also erforderlich, dass die analoge optische Signalübertragungsvorrichtung zuverlässige quantitative Messergebnisse, betreffend die genannten Vorgänge im und am jeweiligen Supraleiter-Element, an den Ort des Empfängers überträgt.

Diese Aufgabenstellung wird durch ein Verfahren nach Anspruch 1 und einer Vorrichtung zum Durchführen dieses Verfahrens nach Anspruch 4 erfindungsgemäß erfüllt und weitere Ausgestaltungen und Weiterbildungen der Erfindung gehen aus den Unteransprüchen hervor.

Die anspruchsgemäße Lehre zum technischen Handeln wird nachfolgend anhand der Beschreibung von Schaltbildern beschrieben, deren technische Realisierung die Merkmale der Erfindung erfüllen.

Zur weiteren Erläuterung der Erfindung dienen auch die nachfolgend beschriebenen Figuren, die ebenfalls Offenbarungsinhalt zur Erfindung enthalten.
- Figur 1: zeigt als Beispiel eine erste Ausführungsform zur Erfindung.
- Figur 1A: zeigt das Diagramm des Leuchtens der Lumineszenz-Diode, das das Messergebnis und die Funktion der Kalibrierung wiedergibt.
- Figur 2: zeigt als weiteres Beispiel eine zweite Ausführungsform.
- Figur 3: zeigt eine noch weitere Ausführungsform zur Erfindung.

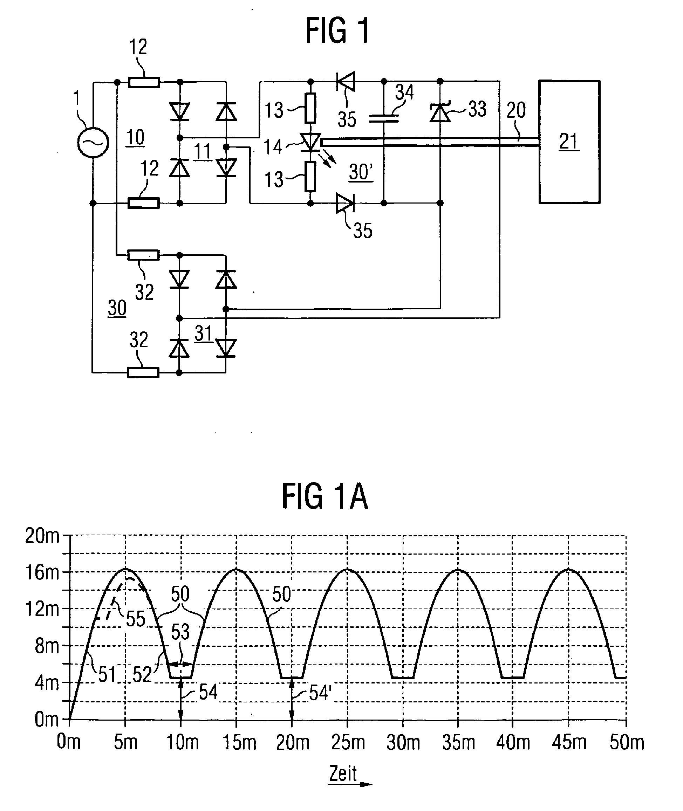

Die Figur 1 zeigt als Schaltbild und Ersatzschaltbild eine Ausführungsform der Erfindung. Mit 1 ist in diesem Schaltbild die Spannungsquelle des o.a. Wechselsignals bezeichnet. Die an dieser Quelle 1 auftretende z.B. elektrische Spannung beruht auf einem elektrischen Abgriff an Anschlüssen eines z.B. supraleitenden Elements eines wie oben beschriebenen Strombegrenzers, nämlich an den einander entgegengesetzten Anschlüssen eines solchen Elements. Im supraleitenden Zustand dieses Elements ist diese Spannung an der Quelle 1 andauernd gleich 0 Volt. Bei Übergang in normalleitenden Zustand des Elements, dem sogenannten Quench-Fall, tritt jedoch an dieser Quelle die Spannung gleich dem Spannungsabfall am nunmehr nicht mehr supraleitenden Element auf. Da das Element von einem Wechselstrom durchflossen wird und somit an der Quelle 1 Wechselspannung auftritt, ist in dem Schaltkreis 10 der Messwerterfassung eine Doppelwegs-Gleichrichtung 11 vorgesehen. Mit 12 sind Ohm'sche Vorwiderstände bezeichnet. Die gleichgerichtete Spannung des Ausgangs der Doppelwegs-Gleichrichtung 11 liegt über Widerstände 13 an einer Licht bzw. optische Strahlung emittierenden Diode 14 an. Nachfolgend wird eine solche Diode jeglicher hier verwendbarer Art - z.B. eine Laserdiode - als Lumineszenz-Diode bezeichnet. Tritt der normalleitende Zustand des ansonsten supraleitenden Elementes ein, liegt eine jeweilige elektrische Spannung an der Lumineszenz-Diode 14, die damit zu leuchten beginnt. Das von der Höhe der an der Lumineszenz-Diode 14 anliegenden elektrischen Spannung hinsichtlich seiner Leuchtintensität abhängige optische Leuchtsignal der Lumineszenz-Diode 14 wird über eine Kunststoff- oder Glasfaser-Leitung 20 einer Auswerteeinrichtung zugeführt. In dieser wird das über die Faser-Leitung aus der Lumineszenz-Diode 14 übertragene optische Signal, das hier z.B. auf dem Übergang des Supraleiter-Elements in Normalleitung beruht, übertragen und je nach Anforderung hinsichtlich seiner Lichtintensität ausgewertet.

Der erfindungsgemäßen Kalibrierung dient der Schaltkreis 30, der mit seinen Anschlüssen der Spannungsquelle 1 parallelgeschaltet ist. Mit 31 ist eine wiederum vorgesehene Doppelwegs-Gleichrichtung bezeichnet. Mit 32 sind Vorwiderstände bezeichnet. Die Ausgangsspannung der Doppelwegs-Gleichrichtung 31 liegt an einer zur Spannungsstabilisierung vorgesehenen Zener-Diode 33 an. Parallel dieser Zener-Diode liegt ein Kondensator 34. Dieser dient der Ladungsspeicherung der an der Zener-Diode ihrer Funktion entsprechend anliegenden stabilisierten elektrischen Spannung. Es ist dies die Referenzspannung U_{ref} gemäß der Erfindung, die hier erfindungsgemäß aus dem Messsignal der Quelle 1 stromversorgt erzeugt ist.

Mit 35 sind Dioden bezeichnet, die den Schaltkreis 30 mit der Zener-Diode 33 und dem Kondensator 34, d.h. den Schaltkreis der Referenzspannung U_{ref}, vom Stromkreis 10 der Messwerterfassung trennen. Die an der Zener-Diode 33 und dem parallel liegenden Kondensator 34 anliegende Referenzspannung U_{ref} wird z.B. so dimensioniert, dass die Lumineszenz-Diode 14 immer noch mit Strom, dann aber aus dem Stromkreis 30, gespeist wird, wenn der die Lumineszenz-Diode 14 aus dem Schaltkreis 10 speisende elektrische Strom nur noch weniger als z.B. 15% des Spitzenwerts des Stromes dieses Stromkreises 10 beträgt. Dieser Spitzenwert beruht auf dem schon oben beschriebenen Übergang des Supraleiter-Elements in den normalleitenden Zustand.

Mit der Erfindung ist also vorgesehen und wird erreicht, dass im Quench-Fall mittels der Lumineszenz-Diode 14 mit dem Stromsignal des Schaltkreises 10 zunächst ein dem Messergebnis entsprechendes Leuchtsignal erzeugt wird. Die Figur 1A zeigt in dem Diagramm 50 zunächst einen Anstieg 51 der Höhe des Leuchtsignals der Lumineszenz-Diode 14. Dieser Anstieg beruht auf der Sinusform des durch den oben erwähnten Begrenzer fließenden, zu überwachenden elektrischen Starkstroms und dem Auftreten von Normalleitung, anstelle von ansonsten Supraleitung im Strombegrenzer. Dieser Verlauf 51 entspricht also auch dem momentanen Verlauf der elektrischen Spannung der oben genannten Spannungsquelle 1 am vorgesehenen Strombegrenzer. Der Kurvenanteil 52 des Diagramms 50 beruht auf dem wieder abfallenden Anteil der Sinuswelle des durch den Strombegrenzer fließenden elektrischen Starkstroms. Die Verläufe 51 und 52 geben also für den Quench-Fall das Leuchtsignal der Lumineszenz-Diode 14 wieder, das das Signal des Messergebnisses des Vorgangs im Strombegrenzer repräsentiert. Der Anteil 53 mit der Amplitude 54 des Diagramms 50 beruht auf der Funktion des Schaltkreises 30', zusammen mit der Zener-Diode 33 und dem Speicherkondensator 34. Im zeitlichen Bereich des Nulldurchgangs des durch den Begrenzer fließenden elektrischen Starkstroms liefert die Lumineszenz-Diode 14 ein Leuchtsignal, das auf dem konstanten elektrischen Strom beruht, den der Kondensator 34 zusammen mit der spannungsstabilisierenden Zener-Diode aus dem Schaltkreis 30' liefert. Dieses stromstabilisierte konstante Leuchtsignal 54 wird erfindungsgemäß als Signal für das Kalibrieren der optischen Übertragungsstrecke der Faser-Leitung 20 verwendet. Wie das Diagramm der Figur 1A zeigt, treten die beschriebenen Anteile 51, 52 und 53 des Leuchtsignals periodisch auf, nämlich entsprechend der Periodizität des durch den Strombegrenzer flie-ßenden elektrischen Starkstroms.

Der Schaltkreis mit der Zener-Diode und dem parallelliegenden Kondensator 34 wird aus dem Schaltkreis 30 gespeist und der Schaltkreis 30 wird wiederum aus der Quelle 1 mit der am Begrenzer auftretenden elektrischen Spannung stromversorgt. Es bedarf bei der Erfindung somit keiner besonderen, separaten Stromversorgung von außen. Eine solche Stromversorgung wäre ansonsten über eine hohe Potentialdifferenz hinweg durchzuführen, was die praktizierte optische Faser-Signalübertragung über hohe Potentialdifferenz hinweg ad absurdum führen würde.

Die Figur 1A zeigt mit 55 bezeichnet und gestrichelt dargestellt, einen alternativ auftretenden Verlauf des Leuchtsignals, beruhend hier auf vom Verlauf des Diagramms 50 abweichendem Spannungsverlauf an der Quelle 1. Ein wie mit 55 gezeigter abweichender Verlauf beruht nämlich auf dem Entstehen eines Lichtbogens, der sich innerhalb des Strombegrenzers über die supraleitenden jetzt jedoch normalleitenden Elemente desselben hinweg ausbildet. Ein solcher Lichtbogen kann dort erhebliche zerstörende Wirkung haben. Mit der Erfindung kann somit das Auftreten eines solchen Lichtbogens innerhalb des im Kryostaten befindlichen, abgeschlossenen Gehäuses des Begrenzers festgestellt werden, und zwar an Hand des wie aus der Figur 1A ersichtlichen Unterschiedes der Verläufe des Diagramms 50 und des alternativen Verlaufs 55 bei Lichtbogenbildung. Solche geringen Intensitätsunterschiede im Leuchtsignal der Lumineszenz-Diode müssen aber mit der Erfindung sicher festgestellt werden können. Die erfindungsgemäß vorgesehene Kalibrierung der Signalübertragung mit der Lumineszenzdiode 14 über die Leitung 20 gewährleistet, dass auch solche geringen Unterschiede erfindungsgemäß sicher und eindeutig festgestellt werden können.

Es empfiehlt sich, bei der Erfindung erst den zweiten Referenzwert 54' der Figur 1A zur Kalibrierung der Übertragungseigenschaften der Faser-Leitung 20 zu verwenden. Damit ist sichergestellt, dass der Kondensator 34 tatsächlich bereits auf der mittels der Zener-Diode stabilisierten elektrischen Spannung aufgeladen ist, d.h. die Speisung der Lumineszenz-Diode 14 aus dem Kondensator 34 mit Sicherheit bereits stromstabilisiert erfolgt, somit der Referenzwert 54' zuverlässig zu verwenden ist.

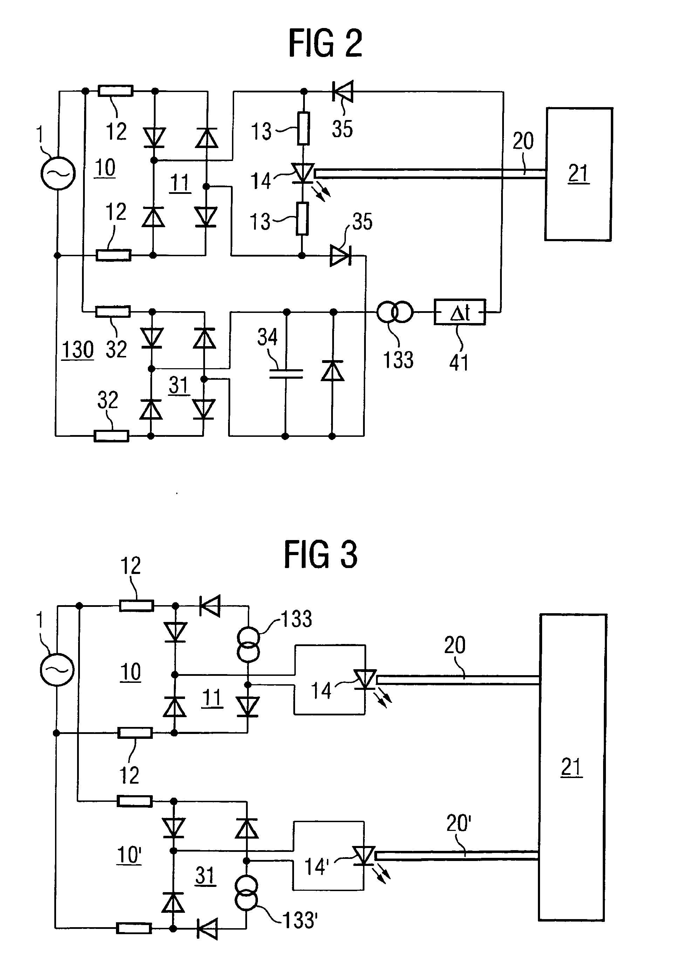

Die Figur 2 zeigt das Schaltbild einer weiteren Ausführungsform der Erfindung. Die zur Figur 1 bereits beschriebenen Einzelheiten der dortigen Schaltung, die bei der Schaltung der Figur 2 gleiche funktionelle Bedeutung haben, tragen in Figur 2 die mit der Figur 1 übereinstimmenden Bezugszeichen.

Mit 41 ist in Figur 2 ein Verzögerungselement bezeichnet. Dieses Verzögerungselement 41 ist so ausgestaltet und bemessen, dass die Speisung der Lumineszenz-Diode 14 zunächst über den Schaltkreis 10 mit dem Messsignal der Quelle 1 erfolgt. Erst verzögert erfolgt dann die Speisung der Lumineszenz-Diode 14 aus dem Schaltkreis 130 mit der Konstantstromquelle 133. Die Verzögerung ist so bemessen, dass somit zeitmultiplex zuerst das Messsignal und danach (oder umgekehrt) das Referenzsignal des Schaltkreises 130 an die Lumineszenz-Diode 14 gelangen. Es werden also zeitlich (nacheinander) das eigentliche Messsignal und das Referenzsignal mittels der Lumineszenz-Diode 14 auf die optische Übertragungsleitung, d.h. die Faser-Leitung 20 übertragen und der Auswertung 21 zugeführt. Entsprechend der Abschaltzeit des mechanischen Abschalters wird die Verzögerungszeit auf ca. 50 ms bemessen.

Eine noch weitere Ausführungsform zeigt die Figur 3. Schon für die Figuren 1 und 2 verwendete Bezugszeichen haben in Figur 3 die gleiche Bedeutung. Die Ausführungsform der Figur 3 weist zwei Faser-Leitungen 20 und 20' auf. Ebenso sind zwei Lumineszenz-Dioden 14 und 14' sowie diesen zugehörig die Schaltkreise 10 und 10' vorgesehen. Mit 133 und 133' sind wiederum Konstantstromquellen bezeichnet. Die Funktionsweise der Ausführungsform nach Figur 3 ist die, dass mit dem einen Schaltkreis 10, der Lumineszenz-Diode 14 und der Faser-Leitung 20 als Signal derjenige Messwert übertragen wird, der der positiven Halbwelle des von dem Begrenzer zu schaltenden Starkstroms entspricht. In der negativen Halbwelle wird der Referenzwert der Konstantstromquelle übertragen. Mit dem Schaltkreis 10', der Lumineszenz-Diode 14' und der Faser-Leitung 20' wird das Signal der negativen Halbwelle des Starkstroms verarbeitet. Beide Halbwellen liegen an der Spannungsquelle 1 an.

Vergleichsweise der Figur 1Awerden die Leuchtsignale der Lumineszenz-Diode 14' über die Faser-Leitung 20' der Auswertung zugeführt.

Mit dem bei der Erfindung verwendeten Zeitmultiplexverfahren wird in denjenigen Zeitabschnitten, in denen im Messsignal, d.h. in der an der Quelle 1 jeweils auftretenden elektrischen Spannung, kein Informationsgehalt enthalten ist, ebenfalls über dieselbe Faser-Leitung ein Referenzwert übertragen. Mit diesem Referenzwert kann die Faser-Leitung 20 bzw. die jeweilige der Faser-Leitungen 20 und 20' in den Pausen des Informationsgehalts auf ihre optische Signalübertragungseigenschaft hin laufend überwacht werden. Diese Überwachung gewährleistet, dass auch solche wie zur Figur 1A beschriebene relativ geringe Veränderungen im Messsignal bzw. Messergebnis nicht nur entdeckt, sondern zuverlässig bewertet werden können. Zum Beispiel ist das Auftreten von Lichtbögen mit der Erfindung daher mit großer Sicherheit bewertbar.

## Patentansprüche

1. Verfahren zur potenzialfreien analogen Signalübertragung mit Kalibrierfunktion für ein an einer Quelle (1) auftretendes elektrisches wechselspannungssignal, bei welchem Verfahren
- das Wechselspannungssignal mittels eines parallel zur Quelle (1) geschalteten Doppelwegs-Gleichrichtungsmittels (11) zu einer gleichgerichteten Ausgangswechselspannung des Doppelwegs-Gleichrichtungsmittels (11) gleichgerichtet wird,
- die gleichgerichtete Wechselspannung am Ausgang des Doppelwegs-Gleichrichtungsmittels (11) mittels einer Lumineszenz-Diode (14, 14') auf einem ersten Potential in ein analoges optisches Wechselsignal transformiert wird,
- dieses analoge optische Wechselsignal
- in eine elektrisch nicht leitende optische zwischen dem ersten elektrischen Potential und einem davon verschiedenen zweiten elektrischen Potential angeordnete Signalübertragungsleitung (20, 20') zur Übertragung zu einer Auswerteeinrichtung (21) eingespeist und
- im Bereich dieses zweiten Potentials in der Auswerteeinrichtung (21) ausgewertet wird,
- zur Kalibrierung der optischen Signalübertragung ein analoges, vorgebbares optisches Kalibrierungssignals (54, 54') aus einem Anteil elektrischer Energie der Quelle (1) erzeugt wird,
- das optische Kalibrierungssignal (54, 54') auf derselben (20) oder der gleichen (20, 20') Signalübertragungsleitung wie der des analogen optischen Wechselsignals zur Auswerteeinrichtung (21) übertragen wird, und
- das optische Wechselsignal und das optische Kalibrierungssignal einem Leuchtsignalverlauf (50) in der Auswerteinrichtung (21) entsprechen, welcher einen dem optischen Wechselsignal zugeordneten ansteigenden und abfallenden Anteil (51; 52) und einen dem optischen Kalibrierungssignal (54, 54') zugeordneten konstanten Anteil (53) aufweist, wobei alle Anteile (51; 52; 53) periodisch auftreten.

2. Verfahren nach Anspruch 1, bei der das optische Wechselsignal (50) und das optische Kalibrierungssignal (54) zeitmultiplex über ein und dieselbe optische Signalübertragungsleitung (20) übertragen werden.

3. Verfahren nach Anspruch 1, bei dem entsprechend den einander abwechselnden, ersten und zweiten Phasen des zu übertragenden Wechselsignals in der ersten Phase desselben das optische Wechselsignal über eine erste optische Signalübertragungsleitung (20) und das optische Kalibrierungssignal (54, 54') gleichzeitig über eine zweite optische Signalübertragungsleitung (20') übertragen werden und in der zweiten Phase des Wechselsignals das optische Wechselsignal über die zweite optische Signalübertragungsleitung (20') und dazu gleichzeitig das optische Kalibrierungssignal (54, 54') über die erste optische Signalübertragungsleitung (20) übertragen wird.

4. Potentialfreie analoge Signalübertragungsvorrichtung mit Kalibrierfunktion für ein elektrisches Wechselspannungssignal einer Quelle (1) zum Durchführen des Verfahrens nach einem der vorangehenden Ansprüche, umfassend mindestens
- ein parallel zur Quelle (1) geschaltetes Doppelwegs-Gleichrichtungsmittel (11) zum Gleichrichten des Wechselspannungssignals zu einer gleichgerichteten Ausgangswechselspannung des Doppelwegs-Gleichrichtungsmittels (11),
- eine mit dem Ausgang des Doppelwegs-Gleichrichtungsmittels (11) verbundene Lumineszenz-Diode (14, 14') auf einem ersten Potential zur Transformation der gleichgerichteten Wechselspannung in ein analoges optisches Wechselsignal,
- eine elektrisch nicht leitende optische Signalübertragungsleitung (20, 20') zwischen diesem ersten elektrischen Potential und einem davon verschiedenen zweiten elektrischen Potential zur Übertragung des analogen optischen Wechselsignal,
- eine Auswerteeinrichtung (21) zur Auswertung des mittels der Signalleitung übertragenen analogen optischen Wechselsignals,
- ein weiteres parallel zur Quelle (1) geschaltetes Doppelwegs-Gleichrichtungsmittel (31), welches
- über Mittel (33, 34) zum Erzeugen einer Referenzspannung U_{ref} und/oder eine Konstantstromquelle (133, 133') mit der Lumineszenz-Diode (14, 14') zur Erzeugung eines analogen, vorgebbaren optischen Kalibrierungssignals (54, 54') aus einem Anteil elektrischer Energie der Quelle (1) verbunden ist, wobei
- als Mittel zum Erzeugen der Referenzspannung U_{ref} eine zwischen dem weiteren Doppelwegs-Gleichrichtungsmittel (31) und der Lumineszenz-Diode (14, 14') parallel geschaltete Parallelschaltung einer Zener-Diode (33) und eines Speicherkondensators (34) vorgesehen sind, und
- zur Kalibrierung der optischen Signalübertragung die Übertragung dieses optischen Kalibrierungssignals (54, 54') auf derselben (20) oder der gleichen (20, 20') Signalübertragungsleitung wie dem des analogen optischen Wechselsignals vorgesehen ist.

5. Signalübertragungsvorrichtung nach Anspruch 4, bei der wenigstens eine Faser-Leitung als optische Signalübertragungsleitung (20, 20') vorgesehen ist.

6. Signalübertragungsvorrichtung nach Anspruch 4 oder 5, bei der für beide Doppelwegs-Gleichrichtungsmittel (11, 31) je eine Konstantstromquelle (133, 133') für zeitlich abwechselnde Kalibrierungssignale vorgesehen ist.

7. Anwendung einer Signalübertragungsvorrichtung nach einem der Ansprüche 4 bis 6 für die Überwachung eines Supraleiter-Strombegrenzers, bei welchem das elektrische Wechselspannungssignal zwischen Anschlüssen des Supraleiter-Strombegrenzers im Quench-Fall anfällt.

8. Anwendung nach Anspruch 7 mit Detektion des Auftretens eines Lichtbogens im Supraleiter-Strombegrenzer.

9. Anwendung eines Verfahrens nach einem der Ansprüche 1 bis 3 für die Überwachung eines Supraleiter-Strombegrenzers, bei welchem das elektrische Wechselspannungssignal zwischen Anschlüssen des Supraleiter-Strombegrenzers im Quench-Fall anfällt.

10. Anwendung nach Anspruch 9 mit Detektion des Auftretens eines Lichtbogens im Supraleiter-Strombegrenzer.

## Claims

1. Method for potential-free analog signal transmission with calibration function for an AC electric signal occurring at a source (1), in which method
- the AC signal is rectified by means of a full-wave rectification means (11) connected in parallel to the source (1) to a rectified output AC voltage of the full-wave rectification means (11),
- the rectified AC voltage at the output of the full-wave rectification means (11) is transformed by means of an LED (14, 14') on a first potential into an analog optical AC signal,
- this analog optical AC signal
- is fed into an electrically non-conductive optical signal transmission line (20, 20') disposed between the first electric potential and a differing second electric potential, for transmission to an evaluation facility (21) and
- is evaluated in the evaluation facility (21) in the area of this second potential,
- for calibration of the optical signal transmission, an analog predefinable optical calibration signal (54, 54') is generated from a part of the electric energy of the source (1),
- the optical calibration signal (54, 54') is transmitted on the same (20) or similar (20, 20') signal transmission line as that of the analog optical AC signal to the evaluation facility (21), and
- the optical AC signal and the optical calibration signal correspond to a luminous signal characteristic (50) in the evaluation facility (21), said signal characteristic having a rising and falling part (51; 52) assigned to the optical AC signal and a constant part (53) assigned to the optical calibration signal (54, 54'), all parts (51; 52; 53) occurring periodically.

2. Method according to Claim 1, in which the optical AC signal (50) and the optical calibration signal (54) are transmitted in time division multiplex over one and the same optical signal transmission line (20).

3. Method according to Claim 1, in which, according to the alternating first and second phases of the AC signal to be transmitted, in the first phase of the said AC signal the optical AC signal is transmitted over a first optical signal transmission line (20) and the optical calibration signal (54, 54') is simultaneously transmitted over a second optical signal transmission line (20') and in the second phase of the AC signal the optical AC signal is transmitted over the second optical signal transmission line (20') and also at the same time the optical calibration signal (54, 54') is transmitted over the first optical signal transmission line (20).

4. Potential-free analog signal transmission device with calibration function for an AC electric signal of a source (1) for executing the method according to one of the preceding claims, comprising at least
- a full-wave rectification means (11) connected in parallel to the source (1) for rectifying the AC signal to a rectified output AC voltage of the full-wave rectification means (11),
- an LED (14, 14') connected to the output of the full-wave rectification means (11) on a first potential for transformation of the rectified AC voltage into an analog optical AC signal,
- an electrically non-conductive optical signal transmission line (20, 20') between this first electric potential and a differing second electric potential for transmission of the analog optical AC signal,
- an evaluation facility (21) for evaluation of the analog optical AC signal transmitted by means of the signal line,
- a further full-wave rectification means (31) connected in parallel to the source (1), which means
- is connected over means (33, 34) for generating a reference voltage U_{ref} and/or a constant current source (133, 133') to the LED (14, 14') for generation of an analog predefinable optical calibration signal (54, 54') from a part of the electric energy of the source (1), where
- as means of generating the reference voltage U_{ref}, a parallel switched parallel connection between the further full-wave rectification means (31) and the LED (14, 14') of a Zener diode (33) and a storage capacitor (34) is provided, and
- for calibration of the optical signal transmission, the transmission of this optical calibration signal (54, 54') on the same (20) or similar (20, 20') signal transmission line as that of the analog optical AC signal is provided.

5. Signal transmission device according to Claim 4, in which at least one fibre line is provided as optical signal transmission line (20, 20').

6. Signal transmission device according to Claim 4 or 5, in which for each of the two full-wave rectification means (11, 31) a constant current source (133, 133') is provided for calibration signals alternating in time.

7. Application of a signal transmission device according to one of Claims 4 to 6 for the monitoring of a superconducting current limiter, in which the AC electric signal arises between terminals of the superconducting current limiter in the quench case.

8. Application according to Claim 7 with detection of the occurrence of an electric arc in the superconducting current limiter.

9. Application of a method according to one of Claims 1 to 3 for the monitoring of a superconducting current limiter, in which the AC electric signal arises between terminals of the superconducting current limiter in the quench case.

10. Application according to Claim 9 with detection of the occurrence of an electric arc in the superconducting current limiter.

## Revendications

1. Procédé pour la transmission de signal analogique sans potentiel avec fonction de calibrage pour un signal électrique de tension alternative apparaissant à une source (1), dans lequel
- le signal de tension alternative est redressé au moyen d'un redresseur pleine-onde (11) branché parallèlement à la source (1) en une tension alternative de sortie redressée du redresseur pleine-onde (11),
- la tension alternative redressée à la sortie du redresseur pleine-onde (11) est transformée au moyen d'une diode à luminescence (14, 14') sur un premier potentiel en un signal alternatif optique analogique,
- ce signal alternatif optique analogique
- est introduit dans une ligne de transmission de signal (20, 20') optique, électriquement non conductrice et branchée entre le premier potentiel électrique et un deuxième potentiel électrique différent du premier, en vue de la transmission à un dispositif d'évaluation (21), et
- est évalué au niveau de ce deuxième potentiel dans le dispositif d'évaluation (21),
- pour le calibrage de la transmission de signal optique, un signal de calibrage optique, analogique et pouvant être prescrit (54, 54') est produit à partir d'une composante d'énergie électrique de la source (1),
- le signal de calibrage optique (54, 54') est transmis au dispositif d'évaluation (21) sur la même (20) ou les mêmes (20, 20') lignes de transmission de signal que celles du signal alternatif optique analogique, et
- le signal alternatif optique et le signal de calibrage optique correspondent dans le dispositif d'évaluation (21) à une allure de signal lumineux (50) qui comporte une composante croissante et décroissante (51 ; 52) associée au signal alternatif optique et une composante constante (53) associée au signal de calibrage optique (54, 54'), toutes les composantes (51 ; 52 ; 53) apparaissant périodiquement.

2. Procédé selon la revendication 1, dans lequel le signal alternatif optique (50) et le signal de calibrage optique (54) sont transmis en multiplexage temporel par l'intermédiaire d'une seule et même ligne de transmission de signal optique (20).

3. Procédé selon la revendication 1, dans lequel, selon les premières et deuxièmes phases alternant du signal alternatif à transmettre, dans la première phase de celui-ci, le signal alternatif optique est transmis par l'intermédiaire d'une première ligne de transmission de signal optique (20) et le signal de calibrage optique (54, 54') est transmis simultanément par l'intermédiaire d'une deuxième ligne de transmission de signal optique (20') et, dans la deuxième phase du signal alternatif, le signal alternatif optique est transmis par l'intermédiaire de la deuxième ligne de transmission de signal optique (20') et le signal de calibrage optique (54, 54') est transmis simultanément par l'intermédiaire de la première ligne de transmission de signal optique (20).

4. Dispositif de transmission de signal analogique sans potentiel avec fonction de calibrage pour un signal électrique de tension alternative d'une source (1) en vue de la mise en oeuvre du procédé selon l'une des revendications précédentes, comprenant au moins :
- un redresseur pleine-onde (11) branché parallèlement à la source (1) pour le redressement du signal de tension alternative en une tension alternative de sortie redressée du redresseur pleine-onde (11),
- une diode à luminescence (14, 14') reliée à la sortie du redresseur pleine-onde (11) sur un premier potentiel pour la transformation de la tension alternative redressée en un signal alternatif optique analogique,
- une ligne de transmission de signal (20, 20') optique et électriquement non conductrice entre le premier potentiel électrique et un deuxième potentiel électrique différent du premier pour la transmission du signal alternatif optique analogique,
- un dispositif d'évaluation (21) pour l'évaluation du signal alternatif optique analogique transmis au moyen de la ligne de signal,
- un autre redresseur pleine-onde (31) qui est branché parallèlement à la source (1) et
- qui est relié par l'intermédiaire de moyens (33, 34) destinés à la production d'une tension de référence U_{ref} et/ou par l'intermédiaire d'une source de courant constant (133, 133') à la diode à luminescence (14, 14') pour la production d'un signal de calibrage optique, analogique et pouvant être prescrit (54, 54') à partir d'une composante d'énergie électrique de la source (1),
- un montage en parallèle composé d'une diode Zener (33) et d'un condensateur de stockage (34) et branché en parallèle entre l'autre redresseur pleine-onde (31) et la diode à luminescence (14, 14') étant prévu comme moyens destinés à la production de la tension de référence U_{ref}, et
- pour le calibrage de la transmission de signal optique, la transmission de ce signal de calibrage optique (54, 54') étant prévue sur la même (20) ou les mêmes (20, 20') lignes de transmission de signal que celles du signal alternatif optique analogique.

5. Dispositif de transmission de signal selon la revendication 4, dans lequel au moins une ligne à fibre optique est prévue comme ligne de transmission de signal optique (20, 20').

6. Dispositif de transmission de signal selon la revendication 4 ou 5, dans lequel, pour les deux redresseurs pleine-onde (11, 31), il est prévu à chaque fois une source de courant constant (133, 133') pour des signaux de calibrage temporellement alternés.

7. Application d'un dispositif de transmission de signal selon l'une des revendications 4 à 6 à la surveillance d'un limiteur supraconducteur de courant, le signal électrique de tension alternative se trouvant en cas de quench entre des bornes du limiteur supraconducteur de courant.

8. Application selon la revendication 7 avec détection de l'apparition d'un arc électrique dans le limiteur supraconducteur de courant.

9. Application d'un procédé selon l'une des revendications 1 à 3 à la surveillance d'un limiteur supraconducteur de courant, le signal électrique de tension alternative se trouvant en cas de quench entre des bornes du limiteur supraconducteur de courant.

10. Application selon la revendication 9 avec détection de l'apparition d'un arc électrique dans le limiteur supraconducteur de courant.
